(19) **Europäisches Patentamt**
**European Patent Office**
**Office européen des brevets**

(11) **EP 4 586 308 A1**

(12) # EUROPEAN PATENT APPLICATION

(43) Date of publication:
**16.07.2025 Bulletin 2025/29**

(21) Application number: **24151842.2**

(22) Date of filing: **15.01.2024**

(51) International Patent Classification (IPC):
***H01L 21/67*** *(2006.01)*

(52) Cooperative Patent Classification (CPC):
**H01L 21/67103; H01L 21/67132; H01L 21/67144**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **FononTech Holding B.V.**
**5581 WG Waalre (NL)**

(72) Inventors:
• **FIJN, Joost**
**5581 WG Waalre (NL)**
• **HENDRIKS, Rob Jacob**
**5581 WG Waalre (NL)**

(74) Representative: **V.O.**
**P.O. Box 87930**
**2508 DH Den Haag (NL)**

(54) **DEPOSITION SYSTEM AND METHOD**

(57)    A deposition system (1) is disclosed herein for heat induced deposition of a donor element (d1, d2, ...,d6) from a donor surface (2s) onto a target surface (Ts). The deposition system comprises at least one heater strip (2), a power supply (3), a selection module (4), a voltage and current sensing facility (6) and a control unit (5). The at least one heater strip (2) comprises a plurality of serially arranged resistive heating elements (h1, h2, ...) for heating respective zones (2s1, 2s2,...) of the donor surface (2s), the resistive heating elements having a temperature dependent resistance. The selection module (4) is configured to alternately supply an electric power from the power supply (3) to a selected one of the serially arranged resistive heating elements. The voltage and current sensing facility (6) is configured to provide sense signals indicative for a voltage and a current of the supplied electric power and the control unit (5) is configured to control a heat flux of each resistive heating element in response to the sense signals.

FIG. 1

EP 4 586 308 A1

## Description

The present invention pertains to a deposition system.

The present invention further pertains to a deposition method.

As known in the art heat induced deposition from a donor surface to a target surface is in principle applicable for a wide range of purposes. In this approach the donor surface of a donor plate is rapidly heated. Therewith the generated heat serves to evaporate a deposition agent so as to induce a vapor pressure that propels a donor element from the donor surface to the target surface.

The deposition agent is for example present in a formulation comprising the donor element to be deposited.

A formulation can e.g. be formed by dispersing a functional material constituting the donor element to be deposited in a solvent or liquid; thus, the formulation is generally wet. The formulation is often referred to as an ink or paste, depending on the viscosity. Examples thereof are a conductive adhesive comprising a thermal or UV settable resin loaded with silver particles, or a solder paste comprising solder particles and flux. Alternatively the functional material may be of a non-conductive nature so as to provide an insulating element on the target surface. A challenge exists to transfer such functional materials, since ideally, instead of printing a functional ink material on a substrate, selectively depositing only the pure functional material on a substrate is most preferable. Such materials e.g. consist of more than 50 vol% e.g. even 90 vol% of a solid state material such as a conductive polymer. Due to their highly viscous nature, e.g. higher than 50 Pa/s to even as much about 1000 Pa/s (10^6 cps). Such materials will not significantly deform due to gravity and flow, but substantial maintain the intended aspect ratio and form definition in the transfer.

EP 4037442 A1 discloses an example of such a heat induced deposition method.

In other examples the donor element to be deposited and the deposition agent are mutually distinct. In that case the vapor pressure induced by heating the deposition agent propels the donor element, e.g. a piece of a donor material or a discrete component from the donor surface towards the target surface.

In this way complex products can be manufactured by subsequent deposition of components, interconnections and insulating elements.

Interconnecting discrete bare chip components or microelectronic components (chips) on a substrate is a process for which precision material deposition with sufficient accuracy is necessary to allow for miniature electrical or other type of interconnects so that when a chip component becomes attached to a placement position all electrical connection and fixation to the substrate can be made by a conductive material or paste.

The transfer behavior strongly depends on the nature of the donor elements to be deposited in the application wherein heat induced deposition is used. There is a need to provide means that facilitate an operator to adapt the deposition process in a predictable way for applications. Also there is a need to provide for scalability of the deposition facilities.

## SUMMARY

It is a first object of the present invention to provide an improved deposition system that addresses one or more of the above-mentioned needs.

It is a second object of the present invention to provide an improved deposition method that addresses one or more of the above-mentioned needs.

According to the first object an improved deposition system is provided as specified in claim 1. The deposition system claimed therein comprises at least one heater strip, a power supply to provide an electric power, a selection module, a voltage and current sensing facility and a control unit.

The at least one heater strip has a plurality of serially arranged resistive heating elements for heating respective zones of the donor surface, which heating elements have a temperature dependent resistance. The power supply serves to provide an electric power and the selection module alternately supplies the electric power to a selected one of the serially arranged resistive heating elements. The voltage and current sensing facility is configured to provide sense signals indicative for a voltage and a current of the supplied electric power. The control unit is configured to control a heat flux of each resistive heating element in response to the sense signals of the voltage and current sensors.

In the improved deposition system the operation of the heating elements can be independently controlled with a minimum of electrical connections in an accurate manner. Therewith a heat flux can be induced that meets the requirements for deposition in arbitrary applications. The deposition system can be easily scaled.

An approximate indication of the power consumed by an individual resistive heating element can be obtained with a voltage and current sensing facility that includes a first voltage sensor to provide a first sense signal indicative for a voltage of the electric power supplied by the power supply and a current sensor to provide a second sense signal indicative for a current of the electric power supplied by the power supply. In an embodiment the voltage and current sensing facility further comprises a second voltage sensor to provide a third sense signal indicative for a voltage between end terminals of the heater strip. An accurate four point measurement can be performed to each selected heating element. Therewith it is avoided that contact resistances of contacts with the resistive heating elements affect the sense results. Preferably the heater strip has dedicated end terminals for sensing the voltage with the second voltage sensor, which are not used for supplying the current of the electric power when the first or the last one of the serially arranged resistive heating elements is selected.

In an embodiment the selection module comprises:

a first series of controllable switching elements having a respective first terminal connected to a first power supply line of the power supply and having a respective second terminal;
a second series of controllable switching elements having a respective third terminal connected to a second power supply line of the power supply and having a respective fourth terminal, and wherein each resistive heating element is connected to a respective pair of a second terminal and a fourth terminal, and wherein each pair of mutually subsequent resistive heating elements is either connected to a shared second terminal or to a shared fourth terminal.

Therewith the sequence of resistive heating elements can be easily activated in a sequence.

In example thereof the heater strip has at a first lateral side respective first electric contacts for connection to respective second terminals and has at a second lateral side respective second electric contacts for connection to respective fourth terminals. In this way a uniform current distribution through each resistive heating element is promoted. It is further favorable for this purpose that the resistive heating elements are provided of a material having a positive temperature coefficient.

In an embodiment the connection to the second terminals and to the fourth terminals is provided by pogo pins. Therewith a resistive heating plate with one or more resistive heating strips can be rapidly electrically connected by placement on the pogo pins.

In an embodiment the power supply comprises a controlled power source and a fine-tuning module configured to control a respective amount of power for each resistive heating element of a heater strip. In case the deposition comprises a plurality of heater strips, each heater strip may have a respective fine-tuning module and these may be connected to the same controlled power source.

In an embodiment the fine-tuning module is configured to charge a capacitive element to a predetermined charge voltage to heat a resistive heating element with a predetermined power. Typically this power supply is configured to alternately perform an operation cycle for each resistive heating element, which operation cycle subsequently comprises a charging stage wherein the electric energy storage element is charged and a discharging stage wherein the stored electric energy is at least partly discharged through the selected resistive heating element. In one example of this embodiment the duration of the discharging stage is substantially larger than the RC-time determined by the capacitive value C of the capacitive element and the resistive value R of the resistive heating element. In that case the capacitive element is fully discharged, at least approximately, each time it is used for supplying an electric power to a selected resistive heating element. Therewith the supplied energy is at least approximately equal to the energy $V^2C$ stored in the capacitor regardless variations in the resistance of the resistive element.

In another example the duration of the discharging stage is substantially shorter than the RC-time, so that the supply voltage during the discharging stage is approximately constant. In both examples the controller in cooperation with the power supply and the selection module can accurately control the heat flux to be provided by each resistive heating element. For example the controller may maintain a lookup table comprising for each resistive heating element an indication of a reference voltage required for the resistive heating element to provide the requested heat flux taking into account the state (e.g. resistance) of the resistive heating element and the donor element and deposition agent used for deposition. In operation the controller subsequently accesses the lookup table with a resistive heating element indication, to retrieve the stored reference voltage of the corresponding resistive heating element and causes the fine-tuning module to charge the electric energy storage element to that reference voltage and subsequently instructs the selection module to supply electric power from the electric energy storage element to the resistive heating element indicated by the resistive heating element indication.

According to the second object an improved deposition method is provided as specified in claim 10. The deposition method for heat induced deposition of a donor element from a donor surface onto a target surface comprises controllably generating a heat flux in a heater strip with a plurality of serially arranged resistive heating elements for heating respective heater zones of the donor surface, and having a temperature dependent resistance. This is achieved in that a provided electric power is alternately supplied to a selected one of the serially arranged resistive heating elements. Therewith a heat flux of each resistive heating element is controlled in response to sense signals indicative for a voltage and a current of the supplied electric power.

In an embodiment the sense signals comprise a first sense signal indicative for a voltage of the supplied electric power, a second sense signal indicative for a current of the supplied electric power and a third sense signal indicative for a voltage between end terminals of the heater strip.

In an embodiment the deposition method comprises a calibration mode and an operational mode. During the calibration mode a resistance of each resistive heating element to be selected is measured, and during the operation mode a compensation is performed to compensate for differences in the measured resistances.

In some cases the steps in this embodiment may involve all resistive heating elements of a heating strip or in case a plurality of heating strips is used all resistive heating elements of all heating strips. In other cases this may not be necessary for example if donor elements need to be deposited only from a subset of heater zones.

An embodiment of the deposition method comprises estimating a thermal behavior of a substance present in a heater zone. For example in a test run a series of heating elements is resistively heated with a mutually different supply power and it is verified which supply power is most suitable to perform the deposition. For example subsequent to performing the test run the respective resistances of the series of heating elements are measured. In case it is detected that the sensed resistance of a heating element is outside a predetermined resistance range this indicates that the deposition of the substance from a heater zone to the target surface was not successful. In this case the heating behavior of the heater zone is affected by the remaining substance. Therewith the heat flux to be induced during actual production can be estimated.

In an embodiment the supply voltage for driving the resistive heating elements is supplied directly by a controlled power supply, for example using pulse width modulation to supply power with the predetermined magnitude to each resistive heater element.

An embodiment of the deposition method comprises alternately charging a supply capacitance and discharging the supply capacitance through the selected one of the serially arranged resistive heating elements. This renders it possible to render a high heat flux with a modest main supply power. For example the supply capacitance is charged in a few ms and discharged in a few to a few tens of microseconds.

The voltage with which the supply capacitance is charged is adapted to provide a predetermined discharge power regardless variations in resistance. For example to achieve a predetermined discharge power Pdch in a resistive heating element having a resistive value Rh, the voltage is set to a value

$$V = \sqrt{P_{dch}R_h}$$

It is noted that the resistance of the heating element is typically temperature dependent. This affects the actual power delivered to the resistive heating element during operation. This influence can be compensated for by a correction parameter $\alpha$. It is further noted that the voltage of the supply capacitance drops while discharging. In practical embodiments a supply capacitance may have a sufficient capacity to reduce the voltage drop to less than a few percent, e.g. less than 5%. Also this influence may be compensated by a correction parameter $\beta$. Taking these aspects into account the voltage is set to a value Vcorr:

$$V_{corr} = \alpha\beta\sqrt{P_{dch}R_h}$$

BRIEF DESCRIPTION OF THE DRAWINGS

These and other aspects are described in more detail with reference to the drawing. Therein:

FIG. 1 schematically shows an embodiment of an improved deposition system;
FIG. 2 and FIG. 2A show aspects of an embodiment of the deposition system in more detail. FIG. 2A shows a further detail;
FIG. 3, 3A, 3B show an example of a heater plate comprising a plurality of heater strips extending in respective rows; Therein FIG. 3 is a bottom view of the heater plate and FIG. 3A is an enlarged detail of FIG. 3; FIG. 3B shows a cross-section according to IIIB-IIIB in FIG. 3A;
FIG. 4 shows a power supply of one embodiment of the deposition system in more detail.;
FIG. 5 schematically shows an exemplary mode of operation of an embodiment of the deposition system;
FIG. 6 shows an embodiment of a deposition method;
FIG. 7A and 7B shows exemplary measurements which may be part of the deposition method;
FIG. 8 illustrates a practical implementation of components in an embodiment of the deposition system;

DETAILED DESCRIPTION OF EMBODIMENTS

Like reference symbols in the various drawings indicate like elements unless otherwise indicated.

Unless otherwise defined, all technical and scientific terms used herein have the same meaning as commonly understood by one of ordinary skill in the art to which this invention belongs. Although methods and materials similar or equivalent to those described herein can be used in the practice or testing of the present invention, suitable methods and materials are described below. All publications, patent applications, patents, and other references mentioned herein are incorporated by reference in their entirety. In case of conflict, the present specification, including definitions, will control. In addition, the materials, methods, and examples are illustrative only and not intended to be limiting.

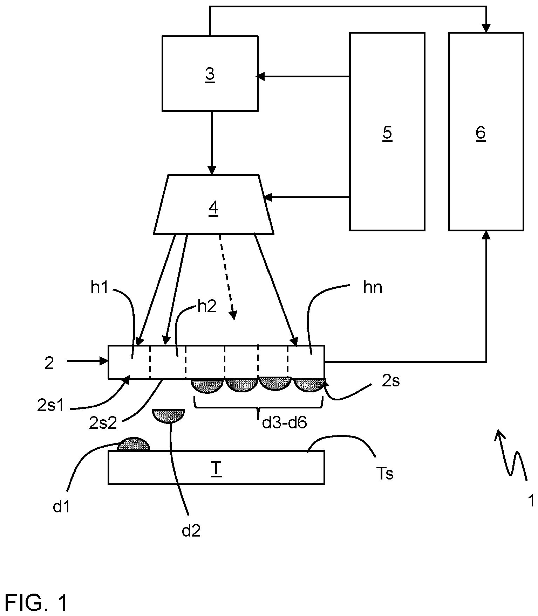

FIG. 1 schematically shows a deposition system 1 for heat induced deposition of a donor element from a donor surface 2s onto a target surface Ts of a target T. The deposition system comprises at least one heater strip 2, a power supply 3, a selection module 4, a voltage and current sensing facility 6 and a control unit 5. The heater strip 2 has a plurality of serially arranged resistive heating elements h1, h2, ... for heating respective zones 2s1, 2s2, ... of the donor surface 2s. The resistive heating elements have a temperature dependent resistance.

Although the plurality of serially arranged resistive heating elements h1, h2, are arranged in the drawing in a linear direction, the resistive heating elements may alternatively be arranged otherwise, e.g. in a spiral. The heater strip may be one of a plurality of heater strips.

The power supply 3 serves to provide an electric power which is alternately supplied by the selection module 4 to a selected one of the serially arranged resistive heating elements. The voltage and current sensing facility 6 provides sense signals indicative for a voltage and a current of the supplied electric power and the control unit 5 controls a heat flux of each resistive heating element in response to the sense signals.

In one embodiment the control unit 5 causes the power supply 3 and the selection module 4 to provide the electric power to each resistive heating element h1, h2, ... for a duration long enough to provide a fluency sufficient to deposit a donor element present on the corresponding zone 2s1, 2s2, ... onto the target surface Ts. Therewith the zone 2s1, 2s2, ... of the donor surface 2s is heated to a temperature at which a deposition agent is evaporated so that the resulting vapor pressure induces the transfer of the donor element to the target surface. As mentioned above, the deposition agent may pe provided as a component in a composition comprising the functional material constituting the donor element to be deposited. Alternatively the deposition agent may be present as a distinct element between the donor surface and the donor element. Dependent on the nature of the deposition agent and the nature of the donor element, the heat flux to be applied may be selected from a range of about 50 $kW/cm^2$ to about 1000 $kW/cm^2$. If the heat flux is substantially lower than about 50 $kW/cm^2$, e.g. less than 20 $kW/cm^2$, a relatively long heating pulse is required, as a result of which too much of the composition comprising the donor element to be deposited evaporates or a component to be deposited is damaged. If the heat flux is sufficiently high, it is achieved that in case of a composition of a donor element and a deposition agent only a small layer of the composition at the interface with the donor surface evaporates and a substantial remainder is propelled by the vapor pressure towards the target surface. In case the deposition agent and the donor element are mutually distinct, it is achieved that the donor element is propelled towards the target surface by the vapor pressure of the deposition agent without significant heating of the donor element (e.g. a discrete component such as an IC). If the heat flux is substantially higher than about 1000 $kW/cm^2$, e.g. higher than 1000 $kW/cm^2$, this may result in an overheating of the heater strip 2. A heating pulse should have a duration sufficient to achieve a fluence at which a vapor pressure is formed. In practice it has been found that a fluence of about 0.2 to about 2 $J/cm^2$ suffices. Typically this is achieved with a pulse duration of a few microseconds. A longer pulse duration, and therewith a higher fluence would be possible, but would involve a less efficient operation as a continued heating of the zone does not contribute to the deposition process once the donor element has been propelled towards the target surface. Suitable settings for a particular combination of donor element and deposition agent can be determined in a routine manner in a test run. Therewith mutually different heating zones provided with the combination are resistively heated with respective heat flux and fluence settings and it is verified for which settings a proper transfer has taken place. By way of example in a deposition system comprising a plurality of heater strips, a respective heat flux setting is selected for each heater strip and a respective fluence is set for each nth element of a resistive heater strip

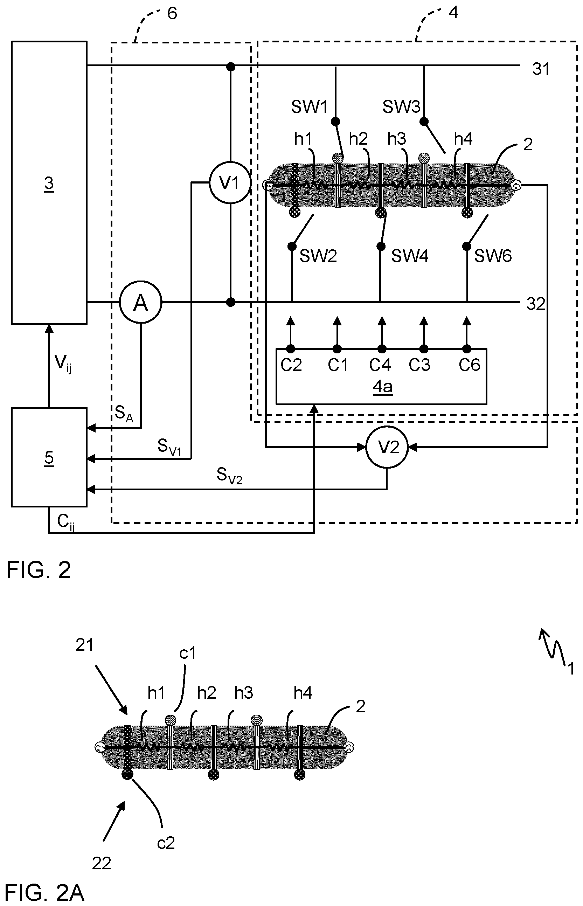

FIG. 2 and FIG. 2A show aspects of an embodiment of the deposition system 1 in more detail. The selection module 4 shown therein comprises a first series of controllable switching elements SW1, SW3,... and a second series of controllable switching elements SW2, SW4, SW6, ... The first series of controllable switching elements SW1, SW3,.. has a respective first terminal connected to a first power supply line 31 of the power supply 3 and has a respective second terminal. The second series of controllable switching elements SW2, SW4, SW6, ... has a respective third terminal connected to a second power supply line 32 of the power supply and has a respective fourth terminal. Each resistive heating element h1, h2,... is connected to a respective pair of a second terminal and a fourth terminal, and each pair of mutually subsequent resistive heating elements is either connected to a shared second terminal or to a shared fourth terminal. For example, the first resistive heating element h1 is connected to the second terminal of the switching element SW1 of the first series and is connected to the fourth terminal of the switching element SW2 of the second series. The subsequent resistive heating element h2, which succeeds the resistive heating element h1 is connected to the second terminal of the switching element SW1 of the first series and is also connected to the second terminal of the switching element SW1 of the first series. It is further connected to the fourth terminal of the switching element SW4 of the second series.

The selection module 4 further comprises a switch controller 4a that controls the switching elements. For example it selectively supplies the power generated by power supply 3 to the first resistive heating element h1 by closing the switching elements SW1 and SW2 with control outputs C1, C2 and leaving opened all other switching elements. Subsequently it may selectively supply the generated power to the second resistive heating element h2 by opening switching element SW2 and closing switching element SW4 with control outputs C2, C4. Due to the fact that the resistive heating elements h1, h2, h3, h4, ... are driven in mutually different time intervals, their performance and condition can be evaluated with a single voltage and current sensing facility 6. In the example shown in FIG. 2, 2A, the voltage and current sensing facility 6 comprises a first voltage sensor V1 and a current sensor A. The first voltage sensor V1 is configured to provide a first sense signal $S_{V1}$ indicative for a voltage of the electric power supplied by the power supply 3 and the current sensor A is configured to provide a second sense signal $S_A$ indicative for a current of the electric power supplied by the power supply. In the embodiment shown the voltage and current sensing facility 6 further comprises a second voltage sensor V2 that is configured to provide a third sense signal $S_{V2}$ indicative for a voltage between end terminals of the heater strip 2.

By way of example, it is presumed that the heater strip 2 is one of a plurality of heater strips. Whereas in this example a heater strip 2 is shown with four resistive heating elements, in practice the heater strips maybe provided with a smaller or larger number of resistive heating elements. For example, the deposition system may have 16 heater strips 2, each with 16 resistive heating elements. In an example the plurality of heater strips may have a common controller 5 and a common voltage and current sensing facility 6. For clarity FIG. 2 shows a single heater strip 2 and a single selection module 4 as well as a single power supply 3. In operation the common controller 5 provides a signal $V_{ij}$ to the power supply 3 that indicates the desired voltage to be delivered to the $j^{th}$ resistive heating element of the $i^{th}$ heater strip. Subsequently it provides a control signal Cij that instructs the selection module 4 of the $i^{th}$ heater strip to activate the $j^{th}$ resistive heating element of the $i^{th}$ heater strip. For example, it instructs the selection module 4 to close switches SW1 and SW4 to deliver the power to the second resistive heating element h2.

In the example shown in FIG. 2A, the heater strip 2 has at a first lateral side 21 respective first electric contacts c1 for connection to respective second terminals and has at a second lateral side 22 respective second electric contacts c2 for connection to respective fourth terminals. This contributes to a uniform current distribution and therewith a uniform heating of the heating elements. In this way also the electrical contacts are well distributed. This is in particular advantageous if the deposition system 1 has a heater surface provided with a plurality of heater strips.

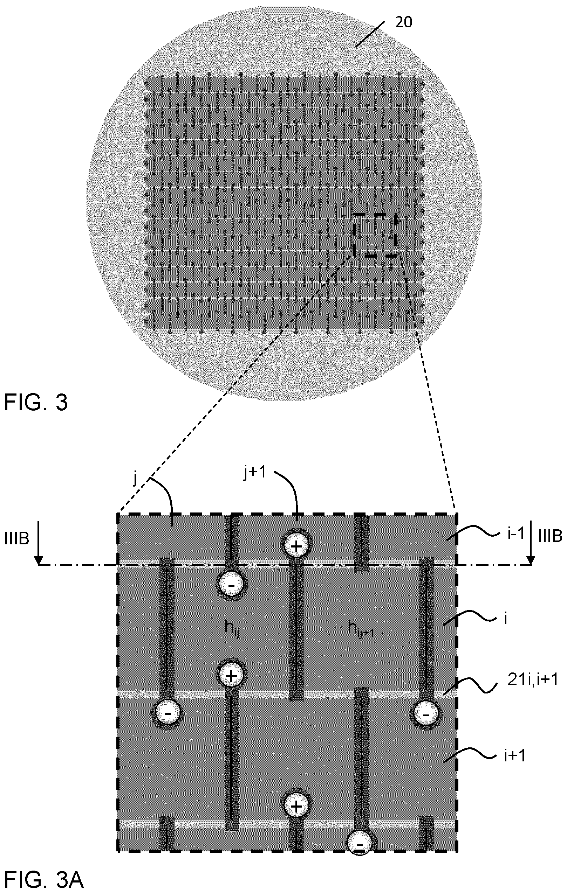

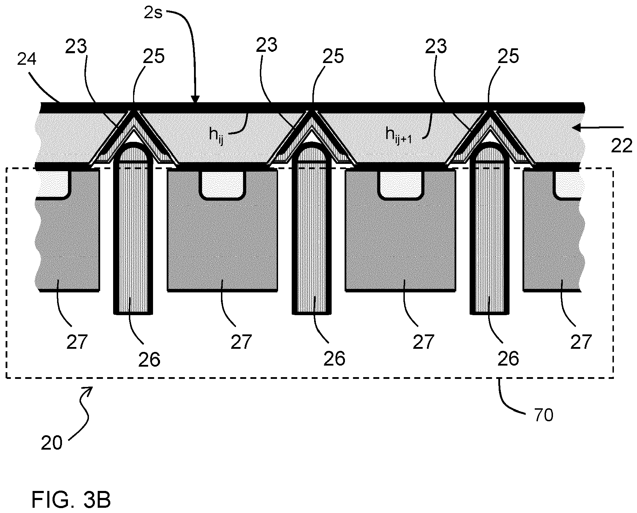

FIG. 3, 3A, 3B show an example of a heater plate 20 comprising a plurality of heater strips extending in respective rows i-1, i, i+1 and each having respective resistive heating element in respective columns j, j+1,... FIG. 3 is a bottom view of the heater plate 20, i.e. a view from a side opposite the donor surface 2s. FIG. 3A is an enlarged detail of FIG. 3. For example reference $h_{ij}$ indicates the $j^{th}$ resistive heating element of the $i^{th}$ heater strip. The heater strips are electrically insulated from each other by insulating boundaries, for example the insulating boundary between the heater strips extending in the rows i and i+1. FIG. 3B shows a cross-section according to IIIB-IIIB in FIG. 3A.

As shown therein, the heater plate 20 comprises a substrate 22 provided with trenches wherein V-shaped busbars 23 are provided. The resistive heating elements $h_{ij}$ are formed as sections of a resistive layer 24, for example a layer of a metal with a low thermal expansion coefficient (CTE) such as Mo, or a CTE matching the substrate, i.e. a silicon substrate. Mo further is advantageous in that it has a positive temperature coefficient which contributes to a homogeneous current distribution and therewith a homogeneous heat flux within the zone of the resistive heating element. Other examples are metals like W, Cr and Ta are examples thereof. Also alloys are suitable, for example W90Ti10 which has 10% titanium for improved adhesion. Also for the busbars 23 it is advantageous if a low CTE metal is used, at least for a layer of the busbar that interfaces with the substrate 22. In the embodiment shown in FIG. 3B the busbars 23 are electrically connected with the resistive heater layer 24 via respective slit-shaped openings 25 through the substrate 22. The resistive heater layer 24 may be covered with a top layer for protection and/or for electrical insulation. As shown in FIG. 3B, an electrical contact with the terminals of the selection module 4 can be efficiently provided by pogo pins 26 of a carrier 70. The carrier 70 may further comprise cooling elements 27 to facilitate a rapid cool down of the heater plate 20.

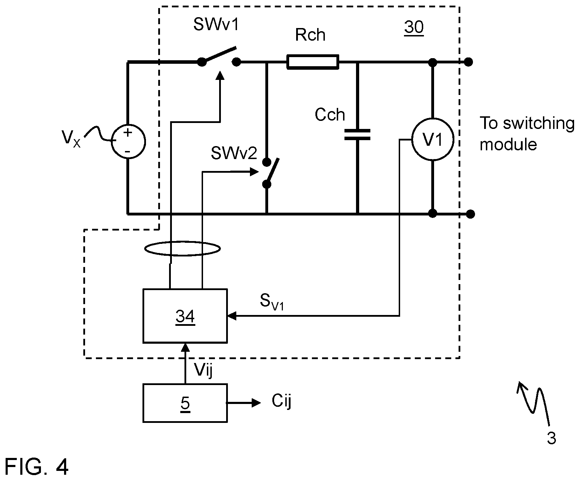

FIG. 4 shows a power supply 3 of one embodiment of the deposition system 1 in more detail. The power supply 3 therein comprises a shared supply unit Vx, and a dedicated fine-tuning module 30 for each heater strip 2. The shared supply can be a state of the art controllable voltage supply, such as a Magna-Power SL500-3. The controller 5 specifies a target voltage $V_{ij}$ for driving the $j^{th}$ element of the $i^{th}$ heater strip. In response to this control signal the fine-tuning module 30 either closes switching element SWv1 or by closes switching element SWv2 until the first sense signal $S_{V1}$ issued by the first voltage sensor indicates that the storage element, capacitor Cch, has assumed the target voltage $V_{ij}$ by charging/-discharging via resistive element Rch. Subsequently the controller 5 issues a control signal Cij to instruct the selection module 4 of the heater strip 2 in row i to empower the $j^{th}$ resistive heating element. In an embodiment the storage capacitor Cch has a capacitive value in the range of ~1-200uF and the resistive element has a resistive value in the range of 10-1000 Ohm, so that the storage capacitor Cch can be rapidly charged to the predetermined voltage value for driving a selected resistive element. For example the pair Rch, Cch has an RC-time in the range of 1 to 10 ms.

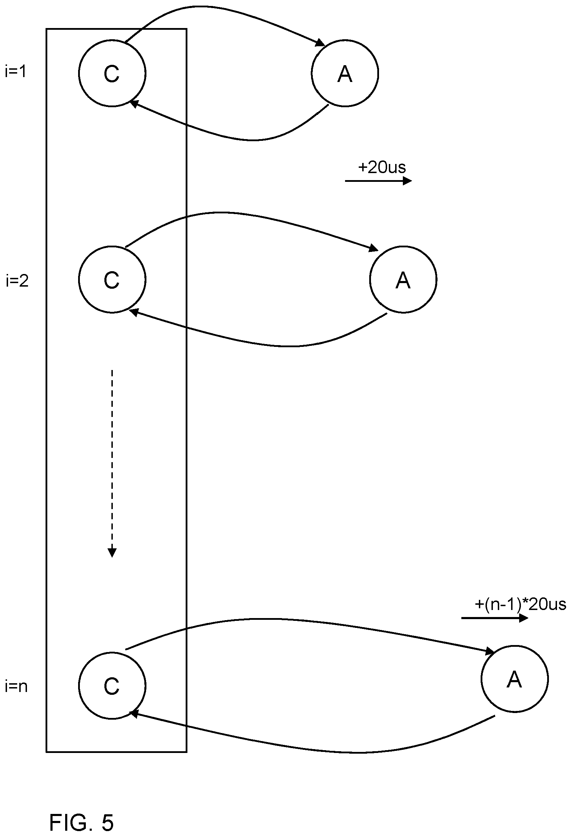

FIG. 5 schematically shows an exemplary mode of operation. In a first stage the respective storage elements Cch of the n fine-tuning modules 30 are simultaneously charged as indicated by symbol C to the specified voltage $V_{ij}$. This may involve a few ms. Subsequently, as indicated by symbol A, the controller 5 instructs the selection modules 4 of the heater strips 2 to empower (activate) their $j^{th}$ resistive heating element. In the example shown this activation takes place on a time-shared basis. Therewith its is possible to measure the performance of the resistive heating elements with a single voltage and current sensing facility 6. Whereas it alternatively is possible to also perform this stage simultaneously for all rows, this would only provide for a limited reduction in time, as heating each resistive heating element can be performed in a few to a few tens of microseconds. In one example of the deposition system 1 first all first resistive heating elements are activated, then the second resistive heating elements and so on, but that is not mandatory. Activation may take place in any order and if desired certain resistive heating elements may be skipped if no donor material is present in their corresponding zones.

The voltage and current sensing facility 6 renders it possible to monitor various operational aspects.

As a first example the sense signals $S_A$, $S_{V1}$, $S_{V2}$, indicate the state of the resistive heating elements. An infinite resistance determined with these signals indicates that a resistive heating element is damaged. As a second example, it has been observed that the resistance of a resistive heating element may gradually change in time. By monitoring this change, the voltage to be supplied can be adapted accordingly so as to achieve a predetermined heat flux irrespective the resistance change. As a third example the resistance of a resistive heating element may be monitored as a function of time during its activation. This indicates whether initially a donor material is present in its corresponding zone and whether the donor material is properly ejected as a result of the activation.

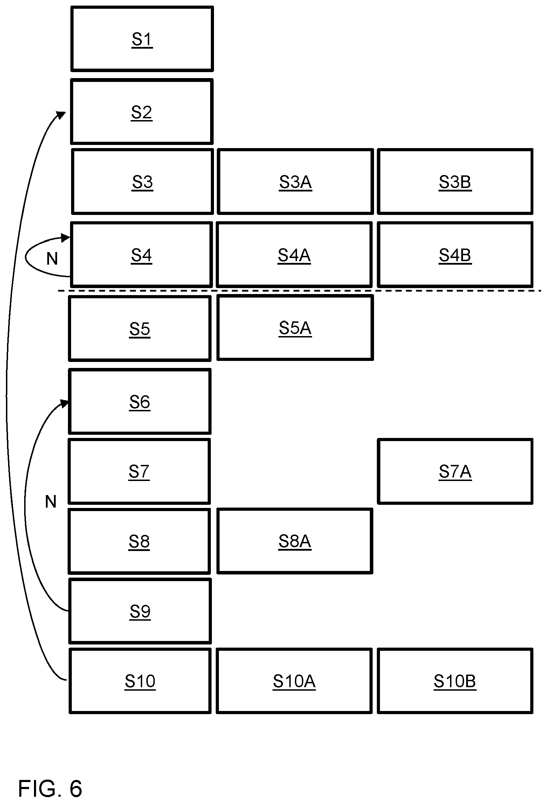

Aspects of a deposition method using the deposition system 1 are described with reference to FIG. 6. In step S1, a user may provide user specific settings, e.g. heat flux, fluence and pulse time settings, to be stored for further use by the controller 5. In step S2 a new heater plate 20 is positioned on the plate carrier 70. In step S3 a calibration is performed. In this calibration it can be determined whether the resistance of the resistive heating elements is within a predetermined range. If this is not the case, i.e. the resistance is too high or too low it is determined that the resistive heating element(s) is broken, in which case the heater plate 20 is replaced. Alternatively, the heater plate 20 may still be used as long as the corresponding zone(s) of the resistive heating element(s) are not used for deposition. The calibration in step S3 may comprise a sub-step S3A wherein the heat flux is measured, proportional to the product of the voltage indicated by signal $S_{V2}$ and the current indicated by the signal $S_A$. In a sub-step S3B an initial voltage is determined for operating each heater element and also an initial voltage is provided for the shared power supply Vx. In step S4 a calibration is performed to determine a suitable heat flux and fluence for ejecting a particular donor material. In practical cases the heat flux is selected a range of about 50 to about 500 kW/cm2 and the fluence is selected in a range of about 0.2 to about 2 J/cm2. In one calibration step S4 a plurality of settings may be simultaneously evaluated. For example, in case the heater plate 20 has 16 rows with each 16 resistive heating elements, the heat flux in the first row is set to 50 kW/cm2 and is stepwise increased each row to finish up with 500 kW/cm2 in the last row. Similarly the fluence is stepwise increased from 0.2 J/cm2 in the first column to 2 J/cm2 in the last column. The heat flux and the fluence may increase linearly but alternatively, the heat flux and/or the fluence may increase proportionally, i.e. with a step size proportional to the value to be increased. Step S4 may be repeated with a different heat flux and/or different fluence range if proper settings have not yet (N) been determined. In an optional sub-step S4A of S4, the voltage and current are measured as a function of time during application of the electric drive pulse to the heater element. Therewith it can be determined in real time whether a donor material present on the heater surface is ejected, and if so, in which stage during application of the pulse. In step S4B, upon completion of these measurements, the respective required output voltages to be delivered by the fine-tuning module 30 via the switching module to each respective heater element are determined. Also the output voltage of the shared power supply Vx is set to deliver a proper supply voltage for the fine-tuning modules 30.

Actual operation starts in step S5 wherein the donor material is placed on the heater plate 20. In step S5A the shared power supply Vx is activated to deliver the proper supply voltage determined in step S4B. Subsequently, in step S6 the heater settings, i.e. the required output voltages, as determined in step S4B are read to enable the fine-tuning module(s) 30 to deliver the proper output voltage for each respective heater element when selected by the switching module, are determined. The steps S7-S8 are performed for each heater element to be activated. In step S7 a heater element is selected to be supplied a voltage pulse with the proper voltage that is set in step S7A in accordance with the heater settings read in step S6. The magnitude of this voltage determines the heat flux. In step S8 the proper voltage is supplied to the selected heating element during a predetermined time interval. The length of the time interval and the magnitude of the supplied voltage determine the fluence. In an optional step S8B the voltage over and current through the selected heater element are measured as a function of time during the application of the voltage pulse. In this optional step it can be verified in real time whether the donor material was properly ejected from a resistive heating element. This optional step may for example be performed as a random check, for example when a heater plate 20 is used for the first time or when it is used for deposition of a new type of donor material. In step S9 it is verified whether or not (N) steps S7-S8 are performed for each heater element to be activated.

Subsequent to the deposition performed in steps S5 to S9, a further verification may be performed in step S10. In this step again the resistive heating elements are driven with a supply voltage to measure their resistance. In case the donor material has been properly ejected it is expected that the measured resistance is back to a reference value. However in case it is determined that the measured resistance of a resistive heating element h1 differs from its reference value, this indicates that donor material remains on its corresponding zone 2s1 of the donor surface 2s. In case it is determined that the resistance is close to 0 or infinitely high it may be concluded that the resistive heating element h1 is out of order, in which case the heater plate 20 may be replaced in step S2. It is noted that the supply voltage for performing the verification in step S 10 may be lower than the operation voltage that is supplied during actual use. However, preferably the supply voltage supplied in step S10 is relatively high to minimize measurement noise and to perform the verification in circumstances that correspond to those during actual use. The verification in step S10 may comprise a sub-step S10A wherein the voltage over and current through the selected heater element are measured as a function of time during the application of the voltage pulse. If it is found that the resistance of a resistive heating element h1 has changed during use, the output voltage setting to be delivered by the fine-tuning module 30 via the switching module to that heater element may be adapted in step S10B. Also the output voltage of the shared power supply Vx may be adapted if necessary.

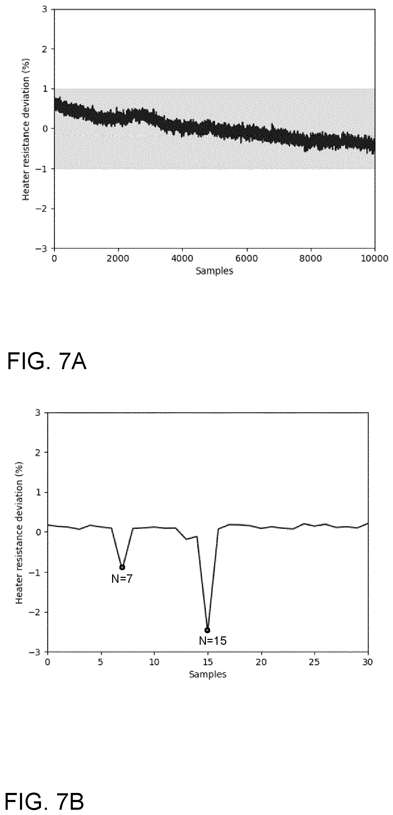

In practice it appears that the resistance of resistive heating elements tends to decrease during use. For example FIG. 7A shows a measured resistance of a resistive heating element relative to a nominal value as a function the number of times it was activated. As shown therein the measured relative resistance decreased from about +0.5% in the measurement following the first activation to about -0.5% after 10.000 activations. It is presumed that the change of resistance is caused by a sintering of the resistive heater material due to the relatively high operational temperatures. In step S10B, the supply voltage to the resistive heating element h1 is decreased so that the supplied heat flux remains the same each time.

As shown in FIG. 7B, incidentally a decreased resistance may be caused by a remainder of donor material on the zone 2s1 of the donor surface 2s with the resistive heating element h1. By way of example the percentual deviation of a nominal resistance value of a resistive heating element is measured caused by deposition of a droplet of a liquid on the corresponding heater zone. The resistance was sampled N=30 times. In case of sample 7 a droplet of distilled water having a diameter of 2 mm was deposited on the heater zone. In case of sample 15 a droplet of distilled water having a diameter of 3 mm was deposited thereon. It can be verified whether or not the resistance assumes a value in a normal range RN or the value remains in a lower range RL. A permanently lower resistance is presumed to be due to wear of the resistive heating element material.

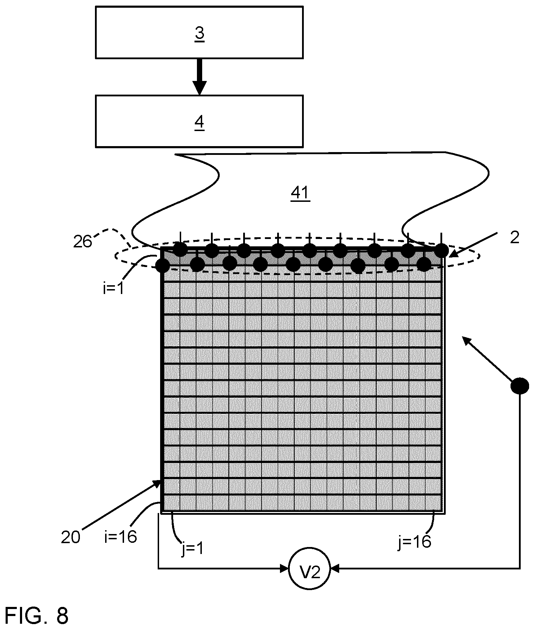

FIG. 8 illustrates a practical implementation of components in an embodiment of the deposition system. As shown therein the selection module 4 of a first row i of heater elements (j = 1 to 16) is connected via a flex-cable 41 to the pogo-pins 26 that electrically contact the electrical contacts of the resistive heating elements of the heater strip 2 in the first row. Likewise, but for clarity not shown in FIG. 8, each of the other rows of heater elements is connected via a respective set of pogo pins of a respective flex-cable 41 to a respective selection module 4. Each row of heater elements may also have a respective power supply 3. Alternatively the rows of heater elements may share a power supply, or may have a shared primary power supply and a dedicated fine tuning component as shown in FIG. 4. The rows of resistive heating element h1 are connected at their end terminals selectively to the voltage sensor V2.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of the "a" or "an" are employed to describe elements and components of the invention. This is done merely for convenience and to give a general sense of the invention. This description should be read to include one or at least one and the singular also includes the plural unless it is obvious that it is meant otherwise.

While the present invention has been described with respect to a limited number of embodiments, those skilled in the art will appreciate numerous modifications and variations therefrom within the scope of this present invention as determined by the appended claims

## Claims

1. A deposition system (1) for heat induced deposition of a donor element (d1, d2, ...,d6) from a donor surface (2s) onto a target surface (Ts), the deposition system comprising:

   at least one heater strip (2) comprising a plurality of serially arranged resistive heating elements (h1, h2, ...) for heating respective zones (2s1, 2s2,...) of the donor surface (2s), the resistive heating elements having a temperature dependent resistance,
   a power supply (3) to provide an electric power;
   a selection module (4; SW1, SW2,...) to alternately supply the electric power to a selected one of the serially arranged resistive heating elements;

a voltage and current sensing facility (6) for providing sense signals indicative for a voltage and a current of the supplied electric power;

a control unit (5) to control a heat flux of each resistive heating element in response to the sense signals.

2. A deposition system (1) according to claim 1, wherein the voltage and current sensing facility (6) comprises:

a first voltage sensor (V1) to provide a first sense signal ($S_{V1}$) indicative for a voltage of the electric power supplied by the power supply (3);
a current sensor (A) to provide a second sense signal ($S_A$) indicative for a current of the electric power supplied by the power supply (3);

a second voltage sensor (V2) to provide a third sense signal ($S_{V2}$) indicative for a voltage between end terminals of the heater strip (2);

3. The deposition system (1) according to claim 1 or 2, wherein the selection module (4) comprises:

a first series of controllable switching elements (SW1, SW3,..) having a respective first terminal connected to a first power supply line (31) of the power supply (3) and having a respective second terminal;
a second series of controllable switching elements (SW2, SW4, SW6, ..) having a respective third terminal connected to a second power supply line (32) of the power supply and having a respective fourth terminal, and wherein each resistive heating element (h1, h2,...) is connected to a respective pair of a second terminal and a fourth terminal, and wherein each pair of mutually subsequent resistive heating elements is either connected to a shared second terminal or to a shared fourth terminal.

4. The deposition system (1) according to claim 3, wherein the heater strip (2) has at a first lateral side (21) respective first electric contacts (c1) for connection to respective second terminals and has at a second lateral side (22) respective second electric contacts (c2) for connection to respective fourth terminals.

5. The deposition system (1) according to claim 4, wherein the connection to the second terminals and to the fourth terminals is provided by pogo pins (26).

6. The deposition system (1) according to one of the preceding claims, wherein the power supply (3) comprises a main power source (Vx) and a fine-tuning module (30) to control a respective amount of power for each resistive heating element (h1, h2,..).

7. The deposition system (1) according to claim 6, wherein the fine-tuning module (30) is configured to charge a capacitive element (Cch) to a predetermined charge voltage to heat a resistive heating element (h1) with a predetermined power.

8. The deposition system (1) according to claim 7, which is configured to alternately perform an operation cycle for each resistive heating element, which operation cycle subsequently comprises a charging stage (C) wherein the capacitive element (Cch) is charged and a discharging stage (A) wherein the stored electric energy is at least partly discharged through the selected resistive heating element (h1)

9. The deposition system (1) according to claim 8, which for the charging stage (C) is configured to receive a resistive heating element indication, to retrieve a reference voltage and to charge the electric energy storage element (Cch) with said reference voltage.

10. The deposition system (1) according to claim 8 or 9, which is configured to measure the resistance of a resistive heating element (h1) during the discharging stage (A) as a function of time.

11. A deposition method for heat induced deposition of a donor element (d1, d2, ..., d6) from a donor surface (2s) on to a target surface (Ts), the method comprising controllably generating a heat flux in a heater strip (2) with a plurality of serially arranged resistive heating elements (h1, h2, ... hn) for heating respective heater zones (2s1, 2s2, ...) of the donor surface (2s), and having a temperature dependent resistance;

providing an electric power (S5A);
alternately supply the electric power to a selected one of the serially arranged resistive heating elements;
providing sense signals indicative for a voltage and a current of the supplied electric power,
controlling the heat flux of each resistive heating element in response to the sense signals.

12. The deposition method according to claim 11, wherein providing sense signals comprises:

providing a first sense signal ($S_{V1}$) indicative for a voltage of the supplied electric power,
providing a second sense signal ($S_A$) indicative for a current of the supplied electric power,
providing a third sense signal ($S_{V2}$) indicative for a voltage between end terminals of the heater strip.

13. The method according to claim 11, comprising a calibration mode and an operational mode, wherein during the calibration mode respective resistances of respective resistive heating elements are measured and wherein during the operation mode a compensation is performed to compensate for differences in the measured resistances.

14. The method according to claim 12 or 13 comprising estimating a thermal behavior of a substance present in a heater zone (2s1, 2s2,...).

15. The method according to claim 12, comprising detecting that the substance is present if a sensed resistance of the heating element is outside a predetermined resistance range.

FIG. 1

FIG. 2

FIG. 2A

FIG. 3

FIG. 3A

FIG. 3B

FIG. 4

i=1

i=2

i=n

+20us

+(n-1)*20us

FIG. 5

FIG. 6

FIG. 7A

FIG. 7B

FIG. 8

## EUROPEAN SEARCH REPORT

**Application Number**

EP 24 15 1842

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y<br><br>A | WO 2021/230746 A1 (TNO [NL])<br>18 November 2021 (2021-11-18)<br>* abstract *<br>* claims 1-14 *<br>* page 2, lines 21-23 *<br>* page 4, lines 1-16 *<br>* page 9, lines 3-16 *<br>* page 17, lines 3-24 *<br>* page 19, line 28 - page 21, line 3 *<br>* figures 1-7 *<br>- - - - - | 1-6,<br>11-13<br>7-10,14,<br>15 | INV.<br>H01L21/67 |
| Y<br><br>A | AU 2015 203 200 A1 (WATLOW ELECTRIC MFG)<br>9 July 2015 (2015-07-09)<br>* abstract *<br>* claims 1-25 *<br>* paragraphs [0021], [0023], [0027],<br>[0051], [0064], [0074], [0105],<br>[0106], [0109] *<br>* figures 1-9b *<br>- - - - - | 1-6,<br>11-13<br>7-10,14,<br>15 | |
| A,D | EP 4 037 442 A1 (TNO [NL])<br>3 August 2022 (2022-08-03)<br>* abstract *<br>* claims 1-17 *<br>* figures 1-7B *<br>- - - - - | 1-15 | **TECHNICAL FIELDS SEARCHED (IPC)**<br><br>H01L |

The present search report has been drawn up for all claims

| Place of search | Date of completion of the search | Examiner |
|---|---|---|
| The Hague | 7 August 2024 | Lachaud, Stéphane |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 15 1842

This annex lists the patent family members relating to the patent documents cited in the above-mentioned European search report.
The members are as contained in the European Patent Office EDP file on
The European Patent Office is in no way liable for these particulars which are merely given for the purpose of information.

07-08-2024

| Patent document cited in search report | | Publication date | Patent family member(s) | | Publication date |
|---|---|---|---|---|---|
| WO 2021230746 | A1 | 18-11-2021 | CN | 115700015 A | 03-02-2023 |
| | | | EP | 3911130 A1 | 17-11-2021 |
| | | | EP | 4151057 A1 | 22-03-2023 |
| | | | JP | 2023525815 A | 19-06-2023 |
| | | | KR | 20230008802 A | 16-01-2023 |
| | | | US | 2023240017 A1 | 27-07-2023 |
| | | | WO | 2021230746 A1 | 18-11-2021 |
| AU 2015203200 | A1 | 09-07-2015 | NONE | | |
| EP 4037442 | A1 | 03-08-2022 | CN | 116941332 A | 24-10-2023 |
| | | | EP | 4037442 A1 | 03-08-2022 |
| | | | EP | 4285694 A1 | 06-12-2023 |
| | | | JP | 2024515924 A | 11-04-2024 |
| | | | KR | 20230135111 A | 22-09-2023 |
| | | | WO | 2022164320 A1 | 04-08-2022 |

EPO FORM P0459

For more details about this annex : see Official Journal of the European Patent Office, No. 12/82

**EP 4 586 308 A1**

**Patent documents cited in the description**

- EP 4037442 A1